# EUROPEAN PATENT APPLICATION

(11) **EP 2 372 782 A1**
(43) Date of publication of application: **05.10.2011**
(21) Application number: 09834541.6
(22) Date of filing: 28.12.2009
(51) Int. Cl.: H01L 31/042, H01L 31/04

(54) **PROTECTIVE SHEET FOR BACK SURFACE OF SOLAR CELL MODULE**

(30) Priority: 26.12.2008 JP 2008333656
(71) Applicant: LINTEC Corporation, Tokyo 173-0001 (JP)
(72) Inventor: TAKANASHI, Yasunari, Tokyo 173-0001 (JP)
(74) Representative: De Groote, Christophe
(86) International application number: PCT/JP2009/007337
(87) International publication number: WO 2010/073735

(57) **Abstract**

A protective sheet for the back surface of a solar cell module that is lightweight and has excellent water vapor barrier properties. The protective sheet for the back surface of a solar cell module is prepared by laminating a base sheet having excellent electrical insulation properties to at least one surface of an aluminum-iron alloy sheet. The iron content of the aluminum-iron alloy sheet is preferably not less than 0.7 mass% and not more than 5.0 mass%. Moreover, the protective sheet for the back surface of a solar cell module preferably has a fluororesin layer, and even more preferably has a heat-adhesive layer.

## Description

### TECHNICAL FIELD

The present invention relates to a protective sheet for the back surface of a solar cell module.
Priority is claimed on Japanese Patent Application No. 2008-333656, filed December 26, 2008, the content of which is incorporated herein by reference.

### BACKGROUND ART

Solar cell modules, which are devices for converting the energy from sunlight into electrical energy, are attracting much attention as systems that are capable of generating electricity without discharging carbon dioxide. These solar cell modules require a high level of electric power generation efficiency, as well as a level of durability that enables the module to be used for long periods, even when used outdoors.
The main structure of a solar cell module is composed of a solar cell that functions as the photovoltaic element, a sealing material which is an electrical insulator that prevents shorts within the electrical circuit, and a casing that encapsulates these components in a sealed state. It is generally thought that improving the performance of the casing is an important factor in enhancing the durability of the solar cell module.

In those cases where a solar cell module is used over a long period, in order to prevent current leakage and corrosion within the electrical circuit inside the solar cell module, a protective sheet for the back surface of the solar cell module (hereinafter also referred to as the "back sheet") must have superior water vapor barrier properties. For this reason, a metal sheet of pure aluminum has conventionally been used as the base sheet of this back sheet (for example, see Patent Document 1).

### CITATION LIST

### PATENT DOCUMENTS

[Patent Document 1] International Patent Publication No. 2007/010706 pamphlet

### DISCLOSURE OF INVENTION

### PROBLEMS TO BE SOLVED BY THE INVENTION

If the thickness of the sheet of pure aluminum is reduced to 20 µm or less in order to lighten the solar cell module and the protective sheet for the back surface, then pinhole occurrence tends to become a problem. If pinholes exist in the back sheet, then the original function of the back sheet in blocking water vapor may be lost, causing a deterioration in the functionality of the overall solar cell module.
The present invention takes the above circumstances into consideration, with an object of providing a protective sheet for the back surface of a solar cell module that is lightweight and has excellent water vapor barrier properties.

### MEANS TO SOLVE THE PROBLEMS

In order to achieve the above object, the present invention adopts the aspects described below.
In other words, the present invention provides: (1) a protective sheet for the back surface of a solar cell module, the protective sheet prepared by laminating a base sheet having excellent electrical insulation properties to at least one surface of an aluminum-iron alloy sheet, (2) the protective sheet for the back surface of a solar cell module according to (1), wherein the iron content of the aluminum-iron alloy sheet is not less than 0.7 mass% and not more than 5.0 mass%, (3) the protective sheet for the back surface of a solar cell module according to (1) or (2), also having a fluororesin layer, and (4) the protective sheet for the back surface of a solar cell module according to any one of (1) to (3), also having a heat-adhesive layer.

In this description and the appended claims, the term "laminating" describes joining two components together via physical and/or chemical bonding. Further, the "protective sheet for the back surface of a solar cell module" may be referred to as simply the "back sheet".

### EFFECT OF THE INVENTION

The present invention is able to provide a protective sheet for the back surface of a solar cell module that is lightweight and has excellent water vapor barrier properties.

### BRIEF DESCRIPTION OF THE DRAWINGS

FIG. 1 is a schematic view illustrating a cross-section of a first embodiment of a back sheet according to the present invention.
FIG. 2 is a schematic view illustrating a cross-section of a second embodiment of a back sheet according to the present invention.
FIG. 3 is a schematic view illustrating a cross-section of a third embodiment of a back sheet according to the present invention.
FIG. 4 is a schematic view illustrating the structure of a solar cell module capable of using a back sheet of the present invention.

### EMBODIMENTS FOR CARRYING OUT THE INVENTION

Embodiments of the present invention are described below with reference to the drawings.

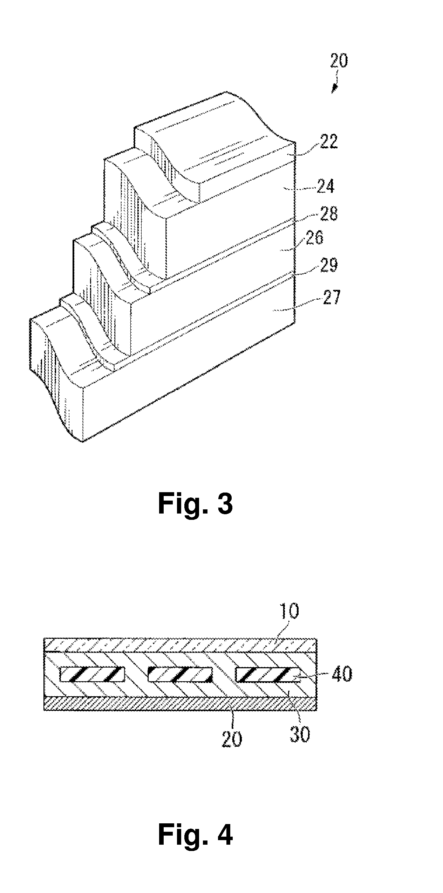

FIG. 4 is a schematic view illustrating the structure of a solar cell module that uses a back sheet of the present invention.
As illustrated in FIG. 4, the structure of a solar cell module that uses a back sheet of the present invention includes a light-transmissive surface layer (front layer) 10, a back surface protective sheet (back sheet) 20, a sealing material (filler layer) 30, and solar cell unit cells 40. In order to impart the solar cell module with the weather resistance and durability necessary to enable the module to be used for long periods outdoors and indoors, the solar cell unit cells 40 and the sealing material 30 must be protected from heavy rain, moisture, dust, and mechanical impacts and the like, and the interior of the solar cell module must be maintained in a sealed state that completely blocks out the external environment. As a result, the back sheet 20 is required to exhibit excellent water vapor barrier properties. Moreover, from the viewpoint of reducing the mechanical load on the solar cell module and the structure in which the solar cell module is installed, it is desirable to reduce the weight of the back sheet 20, thereby reducing the weight of the overall solar cell module.

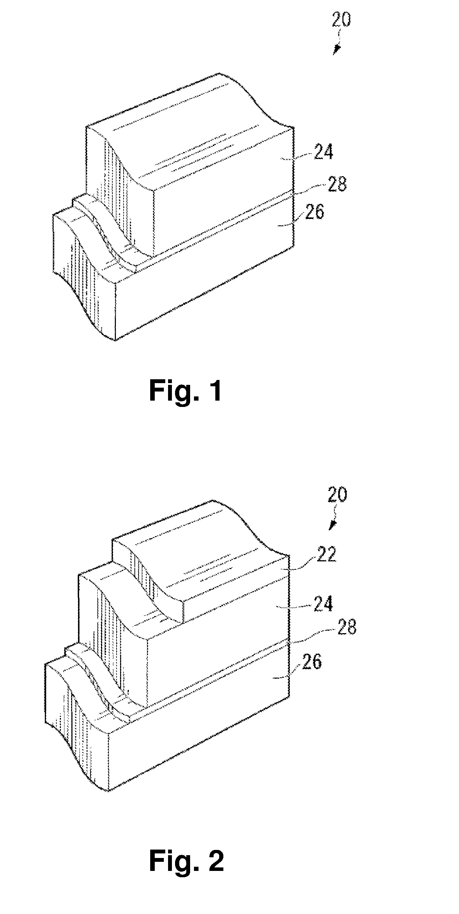

FIG. 1 is a schematic view illustrating a cross-section of a first embodiment of a back sheet according to the present invention.
As illustrated in FIG. 1, the main structure of the back sheet according to the present invention includes an aluminum-iron alloy sheet 24, and a base sheet 26 that is laminated to the aluminum-iron alloy sheet 24.
The back sheet may be a two-layer structure in which the base sheet 26 is laminated to only one surface of the aluminum-iron alloy sheet 24, or a three-layer structure in which base sheets 26 are laminated to both surfaces of the aluminum-iron alloy sheet 24.

The aluminum-iron alloy sheet 24 and the base sheet 26 may be laminated directly together, or an adhesive layer 28 may be provided for the purpose of bonding the two sheets, with the lamination performed with this adhesive layer 28 disposed between the two sheets. In the back sheet of the present invention, from the viewpoint of improving the adhesion between the two sheets, the aluminum-iron alloy sheet 24 and the base sheet 26 are preferably laminated via an above-mentioned adhesive layer 28.

There are no particular limitations on the aluminum-iron alloy sheet 24 used in the present invention provided it does not impair the effects of the present invention, but a sheet of an aluminum-iron alloy containing not less than 0.7 mass% of iron is preferred, a sheet of an aluminum-iron alloy containing 0.7 to 5.0 mass% of iron is more preferred, a sheet of an aluminum-iron alloy containing 1.0 to 2.0 mass% of iron is still more preferred, and a sheet of an aluminum-iron alloy containing 1.2 to 1.7 mass% of iron is the most preferred.

Examples of aluminum-iron alloys having an iron content that satisfies the above-mentioned most preferred range include those alloys classified with the alloy number 8021 prescribed in JIS H4160: 1994. An example of such an aluminum-iron alloy produced in sheet form that can be used favorably is PACAL21 (a product name) manufactured by Nippon Foil Mfg. Co., Ltd. Further, BESPA (a product name) manufactured by Sumikei Aluminum Foil Co., Ltd. can also be used favorably.

By using an aluminum-iron alloy sheet containing an amount of iron that satisfies the range described above, the effect of the present invention can be improved. It is thought that the reason for this improvement is that an aluminum-iron alloy sheet containing an amount of iron that satisfies the above range generally exhibits a degree of rolling workability that is superior to that of pure aluminum, and therefore even when a sheet having a thickness of 20 µm or less is produced, pinhole occurrence is minimal, meaning the circulation of gases through such pinholes is inhibited, and as a result, the water vapor barrier properties of the back sheet according to the present invention that uses the aluminum-iron alloy sheet can be enhanced. Furthermore, it is also thought that an aluminum-iron alloy sheet containing an amount of iron that satisfies the above range generally exhibits a higher level of mechanical strength than a sheet of pure aluminum, thereby enhancing the mechanical strength of the back sheet according to the present invention that uses the aluminum-iron alloy sheet. Moreover, it is also thought that because, as described above, an aluminum-iron alloy sheet containing an amount of iron that satisfies the above range exhibits water vapor barrier properties and a level of mechanical strength that are superior to those of a sheet of pure aluminum, the sheet can be worked to produce a thinner sheet than a pure aluminum sheet while still maintaining these properties, thus enabling a reduction in the weight of the back sheet according to the present invention that uses the aluminum-iron alloy sheet.

The aluminum-iron alloy sheet may contain elements other than iron, provided the effects of the present invention are not impaired. Examples of these other elements include magnesium, manganese, copper, silicon, zinc and titanium. These elements may be unavoidably incorporated within the aluminum-iron alloy during production of the alloy, but it is thought that provided the amounts of these elements are small, the effects of the present invention are not impaired. Here, a "small amount" refers to those cases where the amount of each element is not more than 0.5 mass%, and preferably not more than 0.3 mass%.

There are no particular limitations on the thickness of the aluminum-iron alloy sheet, provided the thickness does not impair the effects of the present invention. However, from the viewpoints of lowering the frequency of pinhole occurrence, ensuring satisfactory the mechanical strength, enhancing the water vapor barrier properties and reducing the weight, the thickness of the aluminum-iron alloy sheet is preferably not more than 30 µm, more preferably not more than 20 µm, and most preferably within a range from 5 to 10 µm.

There are no particular limitations on the above-mentioned base sheet 26 in the present invention, provided the sheet has electrical insulation properties and is capable of supporting the aluminum-iron alloy sheet.

Examples of resin sheets that can be used as the base sheet 26 include those resin sheets typically used as back sheets for solar cell modules. Specific examples include sheets formed from polymers such as polyethylene, polypropylene, polystyrene, poly(methyl methacrylate), polytetrafluoroethylene, polyamide (Nylon 6, Nylon 66), polyacrylonitrile, polyvinyl chloride, polyethylene terephthalate (PET), polyethylene naphthalate (PEN), polyoxymethylene, polycarbonate, polyphenylene oxide, polyester urethane, poly(m-phenylene isophthalamide) and poly(p-phenylene isophthalamide). Of these, sheets formed from a polyester are preferred, and PET sheets are particularly desirable.

The thickness of the base sheet 26 may be selected on the basis of the electrical insulation properties required by the solar cell system. For example, in those cases where the base sheet 26 is a resin sheet, a thickness within a range from 10 to 300 µm is preferred. More specifically, if the base sheet 26 is a PET sheet, then from the viewpoints of lightening the weight while ensuring good electrical insulation properties, the thickness of the PET sheet is preferably within a range from 10 to 300 µm, more preferably from 20 to 250 µm, still more preferably from 30 to 200 µm, still more preferably from 40 to 150 µm, and most preferably from 50 to 125 µm.

Further, the base sheet 26 may be subjected to a surface modification treatment in order to improve the weather resistance and moisture resistance and the like. For example, by using vapor deposition to form a film of silica (SiO₂) and/or alumina (Al₂O₃) on the surface of the above-mentioned PET sheet, the weather resistance and moisture resistance and the like of the back sheet can be improved. The vapor deposition of silica and/or alumina may be performed on either both surfaces of the base sheet 26, or only one of the sheet surfaces. From the viewpoint of improving the weather resistance and the like of the base sheet 26, the vapor deposition of silica and/or alumina is preferably performed on the surface of the base sheet 26 on the opposite side from the surface facing the solar cell unit cells 40.

There are no particular limitations on the method used for laminating the aluminum-iron alloy sheet 24 and the base sheet 26 in the present invention, provided the method does not impair the effects of the present invention. In one example of a preferred method, the aluminum-iron alloy sheet 24 and the base sheet 26 are laminated with an adhesive layer 28 disposed therebetween.

The adhesive layer 28 preferably contains an adhesive that exhibits good adhesion to the aluminum-iron alloy sheet 24 and the base sheet 26.
There are no particular limitations on the adhesive provided it does not impair the effects of the present invention, and examples include acrylic adhesives, urethane adhesives, epoxy adhesives and ester adhesives. These adhesives may be used individually, or two or more adhesives may be used in combination.

Moreover, in order to further improve the adhesion, the surface of the aluminum-iron alloy sheet 24 facing the base sheet 26 may be subjected to a blast treatment. Further, in order to further improve the adhesion, the surface of the base sheet 26 facing the aluminum-iron alloy sheet 24 may be subjected to a corona treatment and/or a chemical treatment.

FIG. 2 is a schematic view illustrating a cross-section of a second embodiment of a back sheet according to the present invention.
As illustrated in FIG. 2, the structure of a back sheet according to the present invention is preferably provided with a fluororesin layer 22 in addition to the aluminum-iron alloy sheet 24 and the base sheet 26. By providing the fluororesin layer 22, the weather resistance of the back sheet according to the present invention can be improved.
From the viewpoint of preventing corrosion of the aluminum-iron alloy sheet, the fluororesin layer 22 is preferably provided so as to contact the surface of the aluminum-iron alloy sheet 24 on the opposite surface from that which is bonded to the base sheet 26.

There are no particular limitations on the fluororesin layer 22, provided it does not impair the effects of the present invention and is a layer that contains fluorine. For example, the fluororesin layer 22 may be a sheet that includes a fluorine-containing polymer, or a coating formed by applying a coating material that includes a fluorine-containing polymer. From the viewpoint of minimizing the thickness of the fluororesin layer 22 so as to reduce the weight of the back sheet, the fluororesin layer 22 is preferably a coating formed by applying a coating material that includes a fluorine-containing polymer.

In those cases where the fluororesin layer 22 is a sheet that includes a fluorine-containing polymer, an adhesive layer 28' may be provided between the fluororesin layer 22 and the aluminum-iron alloy sheet 24, so that the fluororesin layer 22 and the aluminum-iron alloy sheet 24 are laminated with this adhesive layer 28' disposed therebetween. The adhesive layer 28' is as described above for the adhesive layer 28. On the other hand, in those cases where the fluororesin layer 22 is a coating formed by applying a coating material that includes a fluorine-containing polymer, an above-mentioned adhesive layer 28' is normally not required, and the coating material that includes the fluorine-containing polymer may be applied directly to the aluminum-iron alloy sheet 24, thereby laminating the fluororesin layer 22 to the aluminum-iron alloy sheet 24.

Preferred examples of the above-mentioned sheet that includes a fluorine-containing polymer include sheets of a polymer that contains, as the main component, polyvinyl fluoride (PVF), ethylene chlorotrifluoroethylene (ECTFE) or ethylene tetrafluoroethylene (ETFE). Tedlar (a product name) manufactured by E. I. du Pont de Nemours and Company can be used as the polymer containing PVF as the main component. Further, Halar (a product name) manufactured by Solvay Solexis Company can be used as the polymer containing ECTFE as the main component. Moreover, Fluon (a product name) manufactured by Asahi Glass Co., Ltd. can be used as the polymer containing ETFE as the main component.

From the viewpoints of weather resistance and weight reduction, the thickness of the sheet that includes a fluorine-containing polymer is preferably within a range from 5 to 200 µm, more preferably from 10 to 100 µm, and most preferably from 10 to 50 µm.

There are no particular limitations on the coating material that includes a fluorine-containing polymer, provided the material can be dissolved within a solvent or dispersed within water and is able to be applied.

There are no particular limitations on the fluorine-containing polymers that may be included within the coating material, provided the polymer contains fluorine and does not impair the effects of the present invention, but a polymer that dissolves in the above-mentioned coating material solvent (an organic solvent or water) and is capable of cross-linking is preferred. Preferred examples of the fluorine-containing polymer include polymers containing chlorotrifluoroethylene (CTFE) as the main component, such as LUMIFLON (a product name) manufactured by Asahi Glass Co., Ltd., CEFRAL COAT (a product name) manufactured by Central Glass Co., Ltd., and FLUONATE (a product name) manufactured by DIC Corporation, polymers containing tetrafluoroethylene (TFE) as the main component, such as ZEFFLE (a product name) manufactured by Daikin Industries, Ltd., polymers having fluoroalkyl groups such as Zonyl (a product name) manufactured by E. I. du Pont de Nemours and Company and Unidyne (a product name) manufactured by Daikin Industries, Ltd., and polymers containing fluoroalkyl units as a major component. Of these, from the viewpoints of weather resistance and pigment dispersibility and the like, polymers containing CTFE as the main component and polymers containing TFE as the main component are preferable, and of such polymers, the above-mentioned LUMIFLON (a product name) and ZEFFLE (a product name) are the most desirable.

LUMIFLON (a product name) is the name used for a series of amorphous polymers containing CTFE and a number of specific alkyl vinyl ethers and hydroxyalkyl vinyl ethers as the main structural units. Polymers such as LUMIFLON (a product name) that include hydroxyalkyl vinyl ethers as monomer units are particularly desirable as they exhibit superior levels of solvent solubility, cross-linking reactivity, substrate adhesion, pigment dispersibility, hardness and flexibility.
ZEFFLE (a product name) is the name used for a series of copolymers of TFE and a hydrocarbon olefin that is soluble in organic solvents. Of these copolymers, those that employ a hydrocarbon olefin having a highly reactive hydroxyl group are particularly desirable as they exhibit superior levels of solvent solubility, cross-linking reactivity, substrate adhesion and pigment dispersibility.

Further, examples of fluorine-containing polymers that may be included within the coating material include fluoroolefin polymers that contain curable functional groups, and specific examples include copolymers formed from TFE, isobutylene, vinylidene fluoride (VdF), hydroxybutyl vinyl ether and other monomers, and copolymers formed from TFE, VdF, hydroxybutyl vinyl ether and other monomers.

Furthermore, examples of copolymerizable monomers within the fluorine-containing polymer that may be included within the above-mentioned coating material include vinyl esters of carboxylic acids such as vinyl acetate, vinyl propionate, butyl butyrate, vinyl isobutyrate, vinyl pivalate, vinyl caprate, vinyl versatate, vinyl laurate, vinyl stearate, vinyl cyclohexylcarboxylate and vinyl benzoate, alkyl vinyl ethers such as methyl vinyl ether, ethyl vinyl ether, butyl vinyl ether and cyclohexyl vinyl ether, and fluorine-containing monomers such as CTFE, vinyl fluoride (VF), VdF and fluorinated vinyl ether.

Moreover, the fluorine-containing polymer that may be included within the above-mentioned coating material may be a polymer formed from one or more monomers, or may be a terpolymer. One example of a terpolymer is Dyneon THV (a product name, manufactured by 3M Company), which is a terpolymer of VdF, TFE and hexafluoropropylene. This type of multi-component polymer is preferred, as the properties of each of the respective monomers can be imparted to the polymer. For example, the above-mentioned Dyneon THV (a product name) is preferred because it can be produced at comparatively low temperature, can also be bonded to elastomers and hydrocarbon-based plastics, and exhibits excellent flexibility and optical transparency.

Besides the fluorine-containing polymer described above, the coating material may also include one or more cross-linking agents, catalysts and solvents, and if necessary, may also include inorganic compounds such as pigments and fillers.

There are no particular limitations on the solvent included within the coating material provided it does not impair the effects of the present invention, and examples of solvents that can be used favorably include solvents containing one or more of methyl ethyl ketone (MEK), cyclohexanone, acetone, methyl isobutyl ketone (MIBK), toluene, xylene, methanol, isopropanol, ethanol, heptane, ethyl acetate, isopropyl acetate, n-butyl acetate and n-butyl alcohol. Of the various possibilities, from the viewpoints of achieving good solubility of the components within the coating material and minimizing residues within the coating (namely, a low boiling point temperature), a solvent containing one or more of xylene, cyclohexanone and MEK is particularly preferred.

There are no particular limitations on the pigments and fillers that may be included in the coating material, provided they do not impair the effects of the present invention. Examples include titanium dioxide, carbon black, perylene, mica, boron nitride, zinc oxide, aluminum oxide, silica, ultraviolet absorbers, preservatives, and desiccants. More specific examples of preferred materials include Ti-Pure R105 (a product name, manufactured by E. I. du Pont de Nemours and Company), which is a rutile titanium dioxide that has been treated with silicon dioxide for imparting durability, and CAB-O-SIL TS 720 (a product name, manufactured by Cabot Corporation), which is a hydrophobic silica in which the hydroxyl groups at the silica surface have been modified via a dimethylsilicone surface treatment.

In order to improve the weather resistance and abrasion resistance, the coating is preferably cured using a cross-linking agent. There are no particular limitations on this cross-linking agent provided it does not impair the effects of the present invention, and examples of cross-linking agents that can be used favorably include metal chelates, silanes, isocyanates, and melamines. If consideration is given to use of the back sheet for 30 years or more in an outdoor environment, then from the viewpoint of weather resistance, an aliphatic isocyanate is preferred as the cross-linking agent.

There are no particular limitations on the composition of the coating material, provided it does not impair the effects of the present invention, and one example of a coating material composition based on the above-mentioned LUMIFLON is a composition prepared by mixing LUMIFLON (a product name), a pigment, a cross-linking agent, a solvent and a catalyst. In terms of the compositional ratio, based on a value of 100 mass% for the overall coating material, the proportion of LUMIFLON is preferably within a range from 3 to 80 mass%, and more preferably from 10 to 50 mass%, the proportion of the pigment is preferably within a range from 5 to 60 mass%, and more preferably from 10 to 30 mass%, and the proportion of the organic solvent is preferably within a range from 20 to 80 mass%, and more preferably from 30 to 70 mass%.
One example of the organic solvent is a mixed solvent of MEK, xylene and cyclohexanone. Further, an example of the catalyst is dibutyltin dilaurate, which is used for promoting the cross-linking between the LUMIFLON (a product name) and the isocyanate within the organic solvent.

Conventional methods may be used as the method of applying the coating material to the above-mentioned aluminum-iron alloy sheet 24, and for example, the coating material may be applied using a rod coater so as to achieve a desired thickness.
There are no particular limitations on the thickness of the fluororesin layer 22 formed by curing the coating material, provided the thickness does not impair the effects of the present invention, and for example, a thickness of 5 µm or greater is suitable. From the viewpoints of achieving favorable water vapor barrier properties, weather resistance and lightweight properties, the thickness of the fluororesin layer 22 is preferably within a range from 5 to 100 µm, more preferably from 10 to 50 µm, still more preferably from 10 to 40 µm, still more preferably from 10 to 30 µm, and most preferably from 10 to 20 µm.

Although the temperature used during the process for drying the applied coating material may be any temperature that does not impair the effects of the present invention, from the viewpoint of reducing the effects on the aluminum-iron alloy sheet 24 and the base sheet 26, the temperature is preferably within a range from 50 to 130°C.

FIG. 3 is a schematic view illustrating a cross-section of a third embodiment of a back sheet according to the present invention.
As illustrated in FIG. 3, the structure of a back sheet according to the present invention preferably includes a heat-adhesive layer 27 in addition to the aluminum-iron alloy sheet 24 and the base sheet 26. The heat-adhesive layer 27 can be laminated to the base sheet 26.
Further, the back sheet according to the present invention preferably includes a heat-adhesive layer 27 in addition to the aluminum-iron alloy sheet 24, the base sheet 26, and the fluororesin layer 22. The heat-adhesive layer 27 can be laminated to the base sheet 26.
From the viewpoint of the weather resistance of the back sheet, the surface of the base sheet 26 to which the heat-adhesive layer 27 is laminated is preferably the surface of the base sheet 26 on the opposite surface from that which is bonded to the aluminum-iron alloy sheet 24.
By including the heat-adhesive layer 27, the back sheet according to the present invention can be thermally bonded to the sealing material 30 of the solar cell module with comparative ease.

There are no particular limitations on the heat-adhesive layer 27 used in the present invention, provided the layer does not impair the effects of the present invention and is composed of a resin that has a heat-adhesive property. Here, the term "heat-adhesive property" describes the property of exhibiting adhesiveness upon heat treatment. The temperature during the heat treatment is typically within a range from 50 to 200°C.

The resin used as the heat-adhesive layer 27 is preferably a resin composed of a polymer containing, for example, ethylene vinyl acetate (EVA) or a polyolefin as the main component, and is most preferably a resin composed of a polymer containing EVA as the main component. The sealing material 30 is often a sealing resin formed from EVA, and in such cases, by forming the heat-adhesive layer 27 from an above-mentioned resin composed of a polymer containing EVA as the main component, the compatibility and adhesion between the sealing material 30 and the heat-adhesive layer 27 can be improved.

There are no particular limitations on the thickness of the heat-adhesive layer 27 provided the thickness does not impair the effects of the present invention, and the thickness may be set to an appropriate value in accordance with the variety of the heat-adhesive layer 27. For example, the thickness of the heat-adhesive layer described above is preferably within a range from 1 to 200 µm. More specifically, if the heat-adhesive layer 27 is composed of EVA, then from the viewpoints of achieving favorable lightweight properties and electrical insulation properties, the thickness of the EVA layer is preferably within a range from 10 to 200 µm, more preferably from 50 to 150 µm, and most preferably from 80 to 120 µm.

There are no particular limitations on the method used for laminating the heat-adhesive layer 27 and the base sheet 26, provided the method does not impair the effects of the present invention. For example, a solution or dispersion prepared by dissolving the heat-adhesive resin in an organic solvent or dispersing the resin in water may be applied to the base sheet, or a separate adhesive layer 29 may be provided between the base sheet 26 and a heat-adhesive layer 27 that is prepared as a sheet of the heat-adhesive resin, so that the base sheet 26 and the heat-adhesive layer 27 are laminated with this adhesive layer 29 disposed therebetween.

The adhesive layer 29 is preferably a layer containing an adhesive that exhibits good adhesion to the heat-adhesive layer 27 and the base sheet 26.

There are no particular limitations on the above-mentioned adhesive provided it does not impair the effects of the present invention, and examples include acrylic adhesives, urethane adhesives, epoxy adhesives and ester adhesives. In order to further improve the adhesion, the surfaces of the heat-adhesive layer 27 and the base sheet 26 facing the adhesive layer 29 may be subjected to a corona treatment and/or a chemical treatment.

The back sheet according to the present invention has a multilayer structure as described above, and the resins, sheets, adhesives and coating materials (coatings) that constitute each of the layers may include pigments and fillers, provided this does not impair the effects of the present invention. Examples of the pigments and fillers include the same materials as those listed above as pigments and fillers that may be included within the above-mentioned coating material.

By laminating the above-described back sheet 20 of the present invention to the sealed surface of the above-mentioned sealing material 30 that encapsulates the solar cell unit cells 40, the solar cell unit cells 40 and the sealing material 30 inside the solar cell module can be protected from heavy rain, moisture, dust, and mechanical impacts and the like, and the interior of the solar cell module can be maintained in a sealed state that completely blocks out the external environment.
In those cases where the back sheet 20 is laminated to the above-mentioned sealed surface, either the aluminum-iron alloy sheet 24 side of the back sheet 20 may be laminated to the sealed surface, or the base sheet 26 side of the back sheet 20 may be laminated to the sealed surface. Conventional methods may be used for the lamination.

### EXAMPLES

The present invention is described below in further detail using a series of examples, although the present invention is in no way limited by the examples presented below.

### [Example 1]

An aluminum-iron alloy sheet with a thickness of 7 µm (iron content: 1.2 to 1.7 mass%, an aluminum-iron alloy sheet equivalent to the alloy number 8021 prescribed in JIS H4160: 1994, PACAL21 (a product name, manufactured by Nippon Foil Mfg. Co., Ltd.)) and a PET sheet with a thickness of 100 µm were laminated using a urethane adhesive and a conventional dry lamination method, thereby producing a back sheet with a three-layer structure including the adhesive layer. The back sheet was examined for pinholes. The result is shown in Table 1.

### [Examples 2 to 5]

With the exception of altering the thickness of the aluminum-iron alloy sheet to 9, 11, 15 and 20 µm respectively, back sheets were produced in the same manner as Example 1 and subsequently examined for pinholes. The results are shown in Table 1.

### [Comparative Example 1]

A pure aluminum sheet with a thickness of 7 µm (a pure aluminum sheet equivalent to the alloy number 1N30 prescribed in JIS H4160: 1994) and a PET sheet with a thickness of 100 µm were laminated using the same urethane adhesive as that described in Example 1 and a conventional dry lamination method, thereby producing a comparative back sheet with a three-layer structure including the adhesive layer. The back sheet was examined for pinholes. The result is shown in Table 1.

### [Comparative Examples 2 to 5]

With the exception of altering the thickness of the pure aluminum sheet to 9, 11, 15 and 20 µm respectively, comparative back sheets were produced in the same manner as Comparative Example 1 and subsequently examined for pinholes. The results are shown in Table 1.

The pinhole examination mentioned above was performed using a method in which a strong light was irradiated onto one surface of the produced back sheet, the back sheet was observed visually from the opposite surface to that being irradiated, and the number of pinholes through which light was transmitted was counted.

**[Table 1]**

| | Thickness of aluminum-iron alloy sheet (µm) | Thickness of PET sheet (µm) | Number of pinholes (number/m²) |
|---|---|---|---|
| Example 1 | 7 | 100 | 1.41 |
| Example 2 | 9 | 100 | 0.78 |
| Example 3 | 11 | 100 | 0.49 |
| Example 4 | 15 | 100 | 0.27 |
| Example 5 | 20 | 100 | 0.12 |
| Comparative example 1 | 7 | 100 | 5.16 |
| Comparative example 2 | 9 | 100 | 2.34 |
| Comparative example 3 | 11 | 100 | 1.72 |
| Comparative example 4 | 15 | 100 | 0.76 |
| Comparative example 5 | 20 | 100 | 0.39 |

Based on the results shown above for Examples 1 to 5, it is evident that the back sheet according to the present invention has fewer pinholes than a conventional back sheet that uses pure aluminum of the same thickness, and therefore exhibits superior water vapor barrier properties.
Further, it is also evident that for a similar number of pinholes (a similar level of water vapor barrier properties), the thickness of the aluminum sheet can be reduced considerably compared with the equivalent conventional back sheet (of Comparative Examples 1 to 5). In other words, it is clear that the back sheet according to the present invention exhibits lightweight properties that are superior to those of conventional back sheets.

### [Example 6]

An aluminum-iron alloy sheet with a thickness of 7 µm (iron content: 1.2 to 1.7 mass%, an aluminum-iron alloy sheet equivalent to the alloy number 8021 prescribed in JIS H4160: 1994, PACAL21 (a product name, manufactured by Nippon Foil Mfg. Co., Ltd.)) and a PET sheet with a thickness of 250 µm were laminated using the same urethane adhesive as that described in Example 1 and a conventional dry lamination method. Subsequently, an EVA sheet with a thickness of 100 µm was laminated to the other surface of the PET sheet (the opposite surface from the surface to which the aluminum-iron alloy sheet had been laminated) using the same urethane adhesive as that described in Example 1 and a conventional dry lamination method, thereby producing a back sheet with a 5-layer structure including the adhesive layers. The back sheet was subjected to a partial discharge test. The result is shown in Table 2.

### [Examples 7 to 10]

With the exception of altering the thickness of the PET sheet to 125, 100, 75 and 50 µm respectively, back sheets were produced in the same manner as Example 6 and subsequently subjected to a partial discharge test. The results are shown in Table 2.

### [Example 11]

An aluminum-iron alloy sheet with a thickness of 17.5 µm (iron content: 1.2 to 1.7 mass%, an aluminum-iron alloy sheet equivalent to the alloy number 8021 prescribed in JIS H4160: 1994, PACAL21 (a product name, manufactured by Nippon Foil Mfg. Co., Ltd.)) and a PET sheet with a thickness of 75 µm were laminated using the same urethane adhesive as that described in Example 1 and a conventional dry lamination method.
Subsequently, an EVA sheet with a thickness of 100 µm was laminated to the other surface of the PET sheet (the opposite surface from the surface to which the aluminum-iron alloy sheet had been laminated) using the same urethane adhesive as that described in Example 1 and a conventional dry lamination method. A coating including a fluorine-containing polymer was then formed on the other surface of the aluminum-iron alloy sheet (the opposite surface from the surface to which the PET sheet had been laminated), thereby producing a back sheet with a 6-layer structure including the above adhesive layers. The back sheet was subjected to a partial discharge test. The result is shown in Table 2.

The method used for forming the coating including a fluorine-containing polymer is described below.
To 200 g of LUMIFLON LF200 (solid fraction: 60%) manufactured by Asahi Glass Co., Ltd. was added 76.2 g of Ti-Pure R105 (a titanium dioxide manufactured by E. I. du Pont de Nemours and Company), and the resulting mixture was mixed using a mixer with a high shearing force. To the resulting mixed solution was added and mixed 21.4 g of the cross-linking agent Desmodur N3300 (a product name, an aliphatic isocyanate manufactured by Bayer MaterialScience AG). The thus obtained coating material including a fluorine-containing polymer was applied to the surface of the aluminum-iron alloy sheet using a rod coater, and was then dried at 80°C to form a coating with a thickness of 13 µm.

### [Example 12]

Instead of forming a coating including a fluorine-containing polymer in the manner described in Example 11, a sheet including a fluorine-containing polymer (Fluon ETFE, a product name manufactured by Asahi Glass Co., Ltd., thickness: 25 µm) was laminated using the same urethane adhesive as that described in Example 1 and a conventional dry lamination method, thereby producing a back sheet with a 7-layer structure including the adhesive layers. This back sheet was subjected to a partial discharge test. The result is shown in Table 2.

### [Reference Example 1]

A PET sheet with a thickness of 125 µm and an EVA sheet with a thickness of 100 µm were laminated using the same urethane adhesive as that described in Example 1 and a conventional dry lamination method, thereby producing a back sheet with a three-layer structure including the adhesive layer as a reference example. This back sheet was subjected to a partial discharge test. The result is shown in Table 2.

### [Reference Example 2]

With the exception of altering the thickness of the PET sheet to 50 µm, a back sheet was produced in the same manner as Reference Example 1. The back sheet was subjected to a partial discharge test. The result is shown in Table 2.

### [Reference Example 3]

An EVA sheet with a thickness of 100 µm was subjected to a partial discharge test. The result is shown in Table 2.

In the above-mentioned partial discharge test, the partial discharge inception voltage prescribed in IEC 61730-2 was measured in accordance with IEC 60664-1. For this test, a partial discharge tester KPD2050 manufactured by Kikusui Electronics Corporation was used.

**[Table 2]**

| | Thickness of aluminum-iron alloy sheet (µm) | Thickness of PET sheet (µm) | Thickness of EVA sheet (µm) | Partial discharge inception voltage (V) |
|---|---|---|---|---|
| Example 6 | 7 | 250 | 100 | 1850 |
| Example 7 | 7 | 125 | 100 | 1150 |
| Example 8 | 7 | 100 | 100 | 1015 |
| Example 9 | 7 | 75 | 100 | 830 |
| Example 10 | 7 | 50 | 100 | 730 |
| Example 11 | 17.5 | 75 | 100 | 900 |
| Example 12 | 17.5 | 125 | 100 | 1370 |
| Reference Example 1 | - | 125 | 100 | 1200 |
| Reference Example 2 | - | 50 | 100 | 910 |
| Reference Example 3 | - | - | 100 | 790 |

Based on the results shown above for Examples 6 to 12, it is evident that the back sheet according to the present invention exhibits favorable electrical insulation properties.

When the back sheet with a 6-layer structure prepared in Example 11 was measured for water vapor transmission based on ISO 15106-2: 2003, the result was lower than the lower limit of detection of 0.03 g/(m³·24h).

### INDUSTRIAL APPLICABILITY

The present invention can be applied to the provision of a protective sheet for the back surface of a solar cell module that is lightweight and has excellent water vapor barrier properties.

### DESCRIPTION OF THE REFERENCE SIGNS

- 10:: Light-transmissive surface layer
- 20:: Back surface protective sheet
- 22:: Fluororesin layer
- 24:: Aluminum-iron alloy sheet
- 26:: Base sheet
- 27:: Heat-adhesive layer
- 28:: Adhesive layer
- 29:: Adhesive layer
- 30:: Sealing material
- 40:: Solar cell unit cell

## Claims

1. A protective sheet for a back surface of a solar cell module, the protective sheet prepared by laminating a base sheet having excellent electrical insulation properties to at least one surface of an aluminum-iron alloy sheet.

2. The protective sheet for a back surface of a solar cell module according to Claim 1, wherein an iron content of the aluminum-iron alloy sheet is not less than 0.7 mass% and not more than 5.0 mass%.

3. The protective sheet for a back surface of a solar cell module according to Claim 1 or 2, also having a fluororesin layer.

4. The protective sheet for a back surface of a solar cell module according to any one of Claims 1 to 3, also having a heat-adhesive layer.
